## Europäisches Patentamt

## European Patent Office

## Office européen des brevets

(11) Veröffentlichungsnummer: **0 260 615 B1**

## (12) EUROPÄISCHE PATENTSCHRIFT

(45) Veröffentlichungstag der Patentschrift: **29.07.92**

(21) Anmeldenummer: **87113305.4**

(22) Anmeldetag: **11.09.87**

(51) Int. Cl.⁵: **G03F 7/26**

(54) Vorrichtung zum Verarbeiten von fotoempfindlichen Materialien.

(30) Priorität: **18.09.86 DE 3631668**

(43) Veröffentlichungstag der Anmeldung:
**23.03.88 Patentblatt 88/12**

(45) Bekanntmachung des Hinweises auf die
Patenterteilung:
**29.07.92 Patentblatt 92/31**

(84) Benannte Vertragsstaaten:
**DE FR GB**

(56) Entgegenhaltungen:

**PATENT ABSTRACTS OF JAPAN, Band 10,
Nr. 76 (P-440)[2133], 26. März 1986; & JP-A-60
214 359 (FUJI SHASHIN FILM K.K.) 26-10-1985**

(73) Patentinhaber: **HOECHST AKTIENGESELL-
SCHAFT
Postfach 80 03 20
W-6230 Frankfurt am Main 80(DE)**

(72) Erfinder: **Schörnig, Eberhard
Römerstrasse 9
W-6204 Taunusstein 4(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Vorrichtung zum Verarbeiten von fotoempfindlichen Materialien, wie Druckplatten, mit einem schräg nach unten geneigten Eingabetisch, einem ersten Sprührohr mit Düsen zum Aufsprühen von Flüssigkeit auf das fotoempfindliche Material, einer entgegengesetzt zur Materialdurchlaufrichtung rotierenden Bürstenwalze und einem Abquetschwalzenpaar.

Eine derartige Vorrichtung ist aus dem deutschen Gebrauchsmuster 82 00 249 bekannt, in dem eine Vorrichtung zum Entfernen von Korrekturmittel von Druckplatten beschrieben ist. Die bei dieser Vorrichtung hinter dem Sprührohr entgegengesetzt zur Laufrichtung der Druckplatte rotierenden Bürstenwalze bildet unterhalb des Sprührohrs einen keilförmigen Wasserstau aus, der das auf der Druckplatte befindliche Korrekturmittel verdünnt, so daß es die Plattenoberfläche nicht mehr angreift. Die auf der Plattenoberfläche festsitzenden Tropfen des im allgemeinen zähflüssigen Korrekturmittels werden durch die Bürstenwalze mechanisch entfernt und in den Wasserstau geschleudert. Das in dem Wasserstau verdünnte Korrekturmittel fließt mit dem Wasser über die seitlichen Ränder der zu korrigierenden Druckplatte ab, so daß diese hinter der Bürstenwalze lediglich einen dünnen Wasserfilm aufweist, der durch das nachgeschaltete Abquetschwalzenpaar abgequetscht wird. Diese bekannte Vorrichtung ist in einem Gehäuse untergebracht, das eine vorgeschaltete Entwickelstation und eine der Vorrichtung nachgeschaltete Gummierstation aufnimmt. Die von dem Korrekturmittel gereinigte Druckplatte kann dann in der anschließenden Gummierstation nachgummiert werden.

In der europäischen Patentanmeldung 0 080 659 ist ein Verarbeitungsgerät für bildmäßig belichtete, fotoempfindliche Materialien beschrieben, das drei Behandlungszonen aufweist. In einem Gehäuseoberteil sind zwei getrennte, schräg nach unten geneigte Einlauftische angeordnet, die in Eingabeschlitze münden. Ein Wannenunterteil ist integral ausgebildet und nimmt die Wanneneinsätze der drei Behandlungszonen auf. An die Ober- und Unterseite des zu entwickelnden Materials wird die Behandlungsflüssigkeit in jeder der drei Behandlungszonen angetragen. In den Behandlungszonen wird der Reihe nach das Material entwickelt, gespült bzw. gewässert und zuletzt konserviert. Das Korrigieren des entwickelten Materials erfolgt außerhalb des Geräts, wonach dann ein weiterer Konservierungs- bzw. Gummierungsschritt notwendig wird. Hierzu wird das korrigierte, entwickelte Material über den einen Einlauftisch direkt in die Behandlungszone zum Konservieren des entwickelten Materials eingeschoben.

Das in der europäischen Patentschrift 0 050 818 beschriebene Entwicklungsgerät für blattförmiges Material, insbesondere für biegsame Druckplatten, besteht aus einer Zweiwannenkombination mit Trennsteg, mit einer Entwicklerwanne und einer Nachbehandlungswanne und mit herausnehmbaren Einsätzen für Einlaufwalzenpaare und Auslaufwalzenpaare aufweisende Transport- und Führungsmittel zum bogenförmigen Führen des Materials durch Bäder der Behandlungsflüssigkeiten. Vor dem Auslaufbereich der Entwicklerwanne oberhalb der Transportbahn des Materials und teilweise unter dem Flüssigkeitsniveau ist eine rotierende Bürstwalze mit federnd gelagerter, auf der anderen Seite der Transportbahn befindlicher Gegenwalze angeordnet. Die Bürstwalze ist durch eine Schutzhaube abgedeckt, deren eine Unterkante sich bis unter das Entwicklerflüssigkeitsniveau erstreckt.

In der DE-PS 21 64 981 ist eine Entwicklungsvorrichtung für elektrofotografisches Aufzeichnungsmaterial mit einem Einlauf- und einem Abquetschwalzenpaar beschrieben, zwischen denen das Aufzeichnungsmaterial schräg nach unten gerichtet und mit der Bildseite nach oben durchläuft. Zwischen den Walzenpaaren ist über dem Aufzeichnungsmaterial eine Zuführungseinrichtung für den Flüssigentwickler zur Bildung und zur Aufrechterhaltung eines von dem Abquetschwalzenpaar über dem Aufzeichnungsmaterial angestauten Entwicklerbades angeordnet. Die Zuführungsvorrichtung ist durch ein Ablenkteil gegen die Eintrittsstelle des Aufzeichnungmsaterials in das Entwicklerbad abgeschirmt, das durch ein schräg nach unten verlaufendes Stützprofil für das blattförmige Aufzeichnungsmaterial, die Seitenwände und die Abquetschwalzen aufgestaut wird.

Fotoempfindliche Materialien, wie Druckplatten, Fotopapiere und dergleichen Materialien werden häufig nach dem Entwickeln und Gummieren in einer Entwicklungsmaschine mit einem Korrekturmittel von Hand aus nachgebessert. Das Korrekturmittel löst Teile der Gummierung und der entwickelten Schicht des fotoempfindlichen Materials auf und muß anschließend von dem korrigierten entwickelten Material entfernt werden. Dabei ist darauf zu achten, daß das aggresive Korrekturmittel die übrigen Bereiche der entwickelten Oberfläche des Materials nicht angreift und auflöst. Dieser nachträgliche Verarbeitungsschritt des entwickelten Materials einschließlich des Abwaschens des Korrekturmittels wurde bisher von Hand vorgenommen, wobei die Vorrichtung nach der voranstehend erwähnten deutschen Gebrauchsmusterschrift 82 00 249 es ermöglicht, das Abwaschen des Korrekturmittels maschinell vorzunehmen. Da bei dieser bekannten Vorrichtung die von dem Wasserstau abgewandten Borstenbüschel der Bürstenwalze nur sehr wenig Wasser mit sich führen, läßt die Verdünnung und somit das sichere Entfernen des Korrekturmittels von der Plattenoberfläche zu wünschen übrig. Die bekannte Vorrichtung ist für das Abwaschen von Korrekturmittel von der Druckplattenoberfläche ausgelegt, eine Verwendung für einen sonstigen Bearbeitungsschritt, wie das Entwickeln oder Wässern einer Druckplatte, ist nicht vorgesehen.

Aufgabe der Erfindung ist es, eine Vorrichtung der eingangs beschriebenen Art so zu verbessern, daß sie bei sehr kompakter Bauweise wahlweise für einen von zwei Bearbeitungsschritten, wie das sichere Abwaschen von Korrekturmittel von der Oberfläche eines fotoempfindlichen Materials und das Entwickeln der Oberfläche eines fotoempfindlichen Materials, geeignet ist, unter weitgehend schonender Behandlung der Materialoberfläche.

Diese Aufgabe wird erfindungsgemäß dadurch gelöst, daß das Abquetschwalzenpaar, indem an der unteren Abquetschwalze eine Abdichtrakel anliegt, die die tiefste Stelle eines Flüssigkeitsbades nach oben hin abschließt, das Flüssigkeitsbad auf ein so hohes Flüssigkeitsniveau aufstaut, daß die in Materialdurchlaufrichtung vor dem Abquetschwalzenpaar angeordnete Bürstenwalze in das Flüssigkeitsbad teilweise eintaucht und daß das Flüssigkeitsbad bis in eine Vorkammer aufgestaut ist, in der das erste Sprührohr oberhalb des Flüssigkeitsniveaus angeordnet ist und Flüssigkeit in das Flüssigkeitsbad, ohne Abspritzen der Materialoberfläche, einspeist.

Die weitere vorteilhafte Ausgestaltung der Erfindung ergibt sich aus den Merkmalen der Unteransprüche. Von besonderem Vorteil ist die in sich geschlossene, kompakte Bauweise der Vorrichtung, die es ermöglicht, die Vorrichtung an eine entsprechende, an sich bekannte Druckplattenentwicklungsmaschine anzubauen, um beispielsweise bei Verwendung der Vorrichtung als Entwicklungsvorrichtung eine übliche Negativ-Druckplattenentwicklungsmaschine durch die erfindungsgemäße Positiv-Entwicklungsvorrichtung in einfacher Weise zu erweitern. Beim Einsatz der erfindungsgemäßen Vorrichtung als Korrekturmittelabwaschvorrichtung kann sie gleichfalls in einfacher Weise auf eine herkömmliche Negativ-Druckplattenentwicklungsmaschine aufmontiert werden, um diese zu erweitern.

Die Erfindung wird im folgenden anhand der Zeichnungen näher erläutert. Es zeigen:

Figur 1     das Schema einer herkömmlichen Druckplattenentwicklungsmaschine,

Figur 2     ein Schema einer herkömmlichen Druckplattenentwicklungsmaschine, ähnlich wie in Figur 1, ergänzt um eine erfindungsgemäße Vorrichtung, und

Figur 3     eine Schnittansicht der Vorrichtung nach der Erfindung.

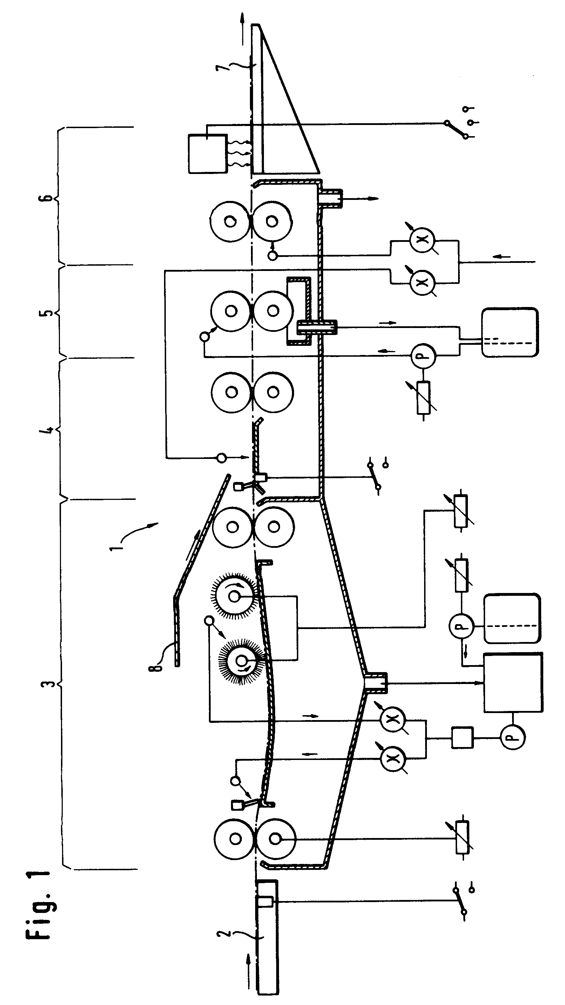

Das in Figur 1 gezeigte Schema einer herkömmlichen Druckplattenentwicklungsmaschine 1 umfaßt einen ersten Eingabetisch 2, eine Entwicklungsstation 3, eine Spülstation 4, eine Gummierstation 5, eine Trockenstation 6, einen Ausgabetisch 7 und einen zweiten Eingabetisch 8 für Druckplatten. Die zu verarbeitende, bildmäßig belichtete Druckplatte wird über den ersten Eingabetisch 2 horizontal in die Druckplattenentwicklungsmaschine 1 eingeschoben. Der Durchlauf der zu verarbeitenden Druckplatte durch die einzelnen Stationen der Entwicklungsmaschine 1 erfolgt längs einer strichpunktiert dargestellten Bahn. Die in die Entwicklungsmaschine 1 eingeschobene Druckplatte wird von einem Einlaufwalzenpaar in der Entwicklungsstation 3 erfaßt und entlang einem Führungsblech weitertransportiert. Über eine Antragsrakel wird Entwicklerflüssigkeit auf die Oberfläche der zu entwickelnden Druckplatte aufgebracht, wobei die Entwicklerflüssigkeit durch ein Sprührohr hindurch auf die Antragsrakel aufgesprüht wird. In der Entwicklungsstation 3 befindet sich desweiteren eine Bürstwalze, die in Durchlaufrichtung der Druckplatte rotiert und von einem Sprührohr aus mit Entwicklerflüssigkeit angesprüht wird. Dieser Bürstwalze ist z.B. eine Plüschwalze mit nicht gezeigtem Sprührohr nachgeschaltet, die entgegen der Durchlaufrichtung der Druckplatte rotiert. Die beiden Bürstwalzen verteilen gleichmäßig die auf der Druckplatte befindliche Entwicklerflüssigkeit. Am Ausgang der Entwicklungsstation 3 befindet sich ein Abquetschwalzenpaar, das die überschüssige Entwicklerflüssigkeit von der Oberfläche der Druckplatte abquetscht. Die abgequetschte Entwicklerflüssigkeit wird von einer Wanne mit einem Ablaß aufgefangen und in einen Vorratsbehälter für Entwicklerflüssigkeit geleitet. In der an die Entwicklungsstation 3 anschließenden Spülstation 4 wird die Oberfläche der entwickelten Druckplatte zunächst abgerakelt und anschließend mit Frischwasser gespült, das von einem Spülrohr auf die Oberfläche der Druckplatte gesprüht wird. Die Spülstation 4 weist gleichfalls ein Abquetschwalzenpaar auf, um überschüssiges Spülwasser von der Oberfläche der Druckplatte abzuquetschen. In der an die Spülstation 4 anschließenden Gummierstation 5 durchläuft die Druckplatte ein Walzenpaar, bestehend aus einer Antragwalze für eine Konservierungsflüssigkeit zum Gummieren der fertig entwickelten Druckplatte und der zugehörigen Gegenwalze. Über ein Sprührohr wird die Konservierungsflüssigkeit mittels nicht gezeigter Rakelschiene auf die Antragwalze aufgebracht. Die Trockenstation 6 umfaßt ein Abquetschwalzenpaar und eine Heizeinrichtung oberhalb der Bahn der Druckplatte. Die untere Abquetschwalze des Abquetschwalzenpaares wird durch Wasserantrag über ein Sprührohr von der Konservierungsflüssigkeit gereinigt, die von der oberen Abquetschwalze auf die untere Abquetschwalze übertragen wird. Die Heizeinrichtung befindet sich am Anfang des Ausgabetisches 7 und trocknet die entwickelte Druckplatte mittels Wärmestrahlen.

Nach dem Entwickeln von Positivdruckplatten sind im allgemeinen Korrekturen notwendig, die manuell vorgenommen werden. Das hierfür verwendete Korrekturmittel wird anschließend abgewaschen, und danach ist eine nochmalige Konservierung der korrigierten, entwickelten Druckplatte erforderlich. Hierfür besitzt eine Positiv-Druckplattenentwicklungsmaschine 1 den zweiten Eingabetisch 8, über den die korrigierte Druckplatte, die außerhalb der Maschine beispielsweise von dem Korrekturmittel gereinigt wurde, schräg in die Spülstation 4 eingegeben wird. Nach dem Spülen erfolgt dann in der Gummierstation 5 der weitere Konservierungsschritt.

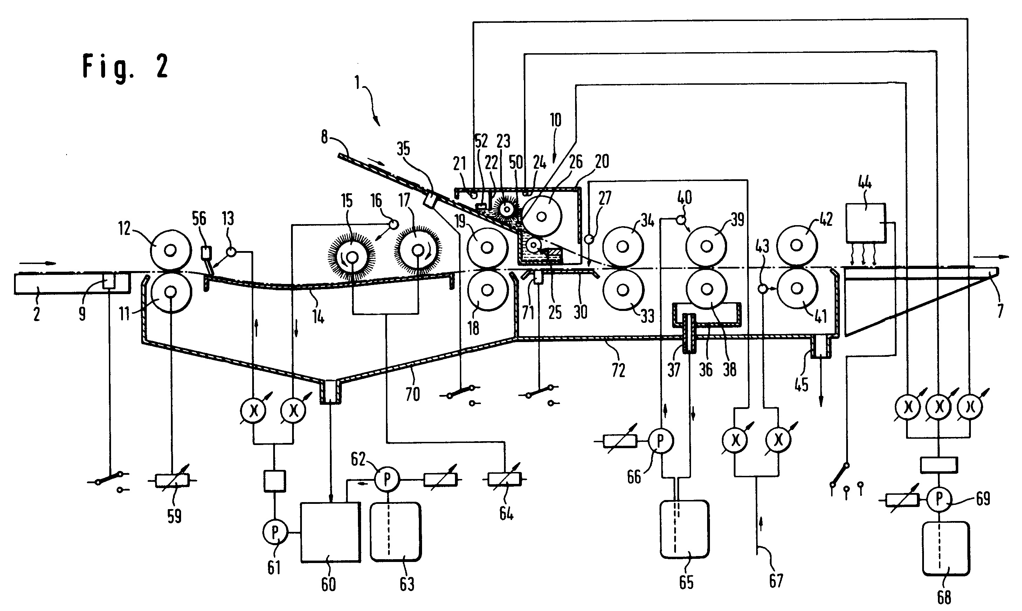

Die in Figur 2 als Schema dargestellte Druckplattenentwicklungsmaschine 1 umfaßt zusätzlich zu der Maschine nach Figur 1 noch eine Vorrichtung 10 nach der Erfindung, die oberhalb des zweiten Eingabetisches 8 montiert ist. Die Vorrichtung 10 wird nachstehend unter Bezugnahme auf Figur 2 noch näher erläutert werden.

Die Vorderkante der einlaufenden Druckplatte wird auf dem Eingabetisch 2 durch einen Sensor 9 erfaßt. Das Transportwalzenpaar 11,12 transportiert die Druckplatte auf ein Führungsblech 14 der Entwicklungsstation 3. In Durchlaufrichtung der Druckplatte befindet sich nahe der vorderen Kante des Führungsblechs 14 eine Rakel 56, die über ein Sprührohr 13 mit Entwicklerflüssigkeit benetzt wird. Das Sprührohr 13 wird von einem Behälter 60 aus, mit Hilfe einer Pumpe 61, mit Entwickler beschickt, ebenso wie ein Sprührohr 16, das Bestandteil dieses Versorgungsleitungssystems ist und schräg oberhalb einer Bürstenwalze 15 angeordnet ist, die den aufgesprühten Entwickler gleichmäßig über die zu entwickelnde Druckplatte verteilt, welche unterhalb der Bürstenwalze 15 entlang der Führungsbahn hindurchläuft.

Die Umlaufgeschwindigkeit der angetriebenen unteren Transportwalze 11 wird durch einen Motorantrieb 59 geregelt, während die obere Transportwalze 12 nicht angetrieben ist.

In Plattendurchlaufrichtung gesehen, ist der Bürstenwalze 15 eine Verteilerwalze 17 mit einem nicht dargestellten Sprührohr nachgeschaltet, die z.B. eine Plüschoberfläche besitzt, um den aufgetragenen Entwickler auf der Plattenoberfläche fein zu verteilen. Die Verteilerwalze 17 kann auch anstelle einer Plüschoberfläche eine sehr feine Bürstenoberfläche aufweisen. Die beiden Walzen 15 und 17 werden synchron von einem gemeinsamen, in der Drehzahl verstellbaren Antrieb 64 in Drehung versetzt. Der überschüssige Entwickler auf der Plattenoberfläche wird von dem Abquetschwalzenpaar 18, 19 am Ausgang der Entwicklungsstation 3 abgequetscht und fließt in eine Auffangwanne 70, welche die Entwicklungsstation 3 nach unten hin abschließt. Diese Auffangwanne 70 hat einen Abfluß in den Behälter 60. Beim Absinken der Entwicklerkonzentration im Behälter 60 wird Entwicklerkonzentrat aus einem Vorratsbehälter 63 mit Hilfe einer Pumpe 62 nachgefüllt.

Die Vorderkante der Druckplatte wird nach dem Verlassen der Entwicklungsstation 3 von einem Sensor 71 erfaßt, dessen Signale die Versorgung von Sprührohren 27 und 43 mit Spülwasser auslöst. Innerhalb der Spülstation 4 läuft die Druckplatte über ein Führungsblech 30 bis zu einem Abquetschwalzenpaar 33,34. Das Sprührohr 27 ist, in Durchlaufrichtung der Druckplatte gesehen, vor dem Abquetschwalzenpaar 33,34 angeordnet. Das Sprührohr 27, ebenso wie das Sprührohr 43, werden über eine gemeinsame Anschlußleitung 67 mit Wasser versorgt. Das aus dem Sprührohr 27 auf die Oberfläche der durchlaufenden Druckplatte aufgesprühte Spülwasser fließt, ebenso wie das von den Abquetschwalzen 33,34 von der Plattenoberfläche abgequetschte Spülwasser, in eine Auffangwanne 72, die sich unterhalb der Spülstation 4 und der Gummierstation 5 erstreckt. Diese Auffangwanne 72 ist mit einem Auslaufrohr 45 ausgerüstet.

Nach dem Durchlauf durch die Abquetschwalzen 33,34 gelangt die Druckplatte in die Gummierstation 5, die ein Walzenpaar 38,39, eine darunter befindliche Wanne 36 mit einem Ablaufrohr 37 aufweist, das in einen Vorratsbehälter 65 führt, der das verwendete Konservierungsmittel zum Gummieren der fertig entwickelten und gespülten Druckplatte enthält. Die obere Walze 39 ist eine Auftragswalze mit nicht gezeigter Rakel für das Konservierungsmittel, während die untere Walze 38 die Gegenwalze zu der Auftragswalze bildet. Das Konservierungsmittel wird von einer Pumpe 66 mit Antrieb zu einem Sprührohr 40 oberhalb der Auftragswalze 39 gefördert, von dem das Konservierungsmittel auf die Oberfläche der Auftragswalze 39 gelangt. Das Ablaufrohr 37 ist durch den Boden der Auffangwanne 72 durchgeführt. Nach dem Verlassen der Gummierstation 5 gelangt die Druckplatte in die Trockenstation 6, die aus einem Trockner 44 und dem Trockner vorgeschalteten Abquetschwalzen 41 und 42 für die überschüssige Gummierung besteht. Die untere Abquetschwalze 41 wird mit Spülwasser aus dem zuvor erwähnten Sprührohr 43 gereinigt.

Bei dem Trockner 44 handelt es sich im allgemeinen um eine Wärmestrahlungsquelle, in Verbindung mit Ventilatoren, die beispielsweise Infrarotstrahler enthält, deren Strahlungsleistung stufenweise geregelt werden kann. Die getrocknete Druckplatte verläßt über den Ausgabetisch 7 die Druckplattenentwicklungsmaschine 1 und kann anschließend von Hand durch Auftragen eines Korrekturmittels korrigiert werden, das Fehlstellen von Positiv-Druckplatten auflöst. Eine derart korrigierte Druckplatte wird dann über den zweiten Eingabetisch 8, der geneigt zur Durchlaufbahn der Druckplatte durch die Maschine 1 verläuft, eingegeben. In Figur 2 ist die Vorrichtung 10 als Korrekturmittelabwaschstation eingesetzt. Eine Abdeckhaube 20 umschließt die Vorrichtung 10 und läßt nur eine Eingabeöffnung 48 und eine Ausgabeöffnung 49 für die Druckplatte offen.

Im Eingabetisch 8 befindet sich ein Sensor 35, der bei der Platteneingabe einen unter die Durchlaufebene abgesenkten, nicht gezeigten Anschlag anhebt, gegen den dann die Vorderkante der Druckplatte anliegt und ausgerichtet wird. Der Anschlag verhindert ein zu schnelles und nicht kantenausgerichtetes Eingeben der Druckplatte, das die Einwirkzeit der Flüssigkeit auf die Druckplatte in einer Vorkammer 47 der Vorrichtung 10 in unerwünschter Weise verkürzen könnte. Die Anschlagbewegung ist mit der Durchlaufgeschwindigkeit der Druckplatte synchronisiert. Nachdem die Hinterkante der Druckplatte den Sensor 35 passiert hat, richtet sich der Anschlag im Abstand zu einer nachfolgenden Druckplatte wieder auf.

Wird die Vorrichtung 10, wie in Figur 2 dargestellt, als Korrekturmittelabwaschstation eingesetzt, so sind Sprührohre 21,24,50 innerhalb der Vorrichtung 10 jeweils in nicht dargestellter Weise entweder über eine gemeinsame Leitung an eine Wasserversorgung angeschlossen oder mit der Anschlußleitung 67 verbunden.

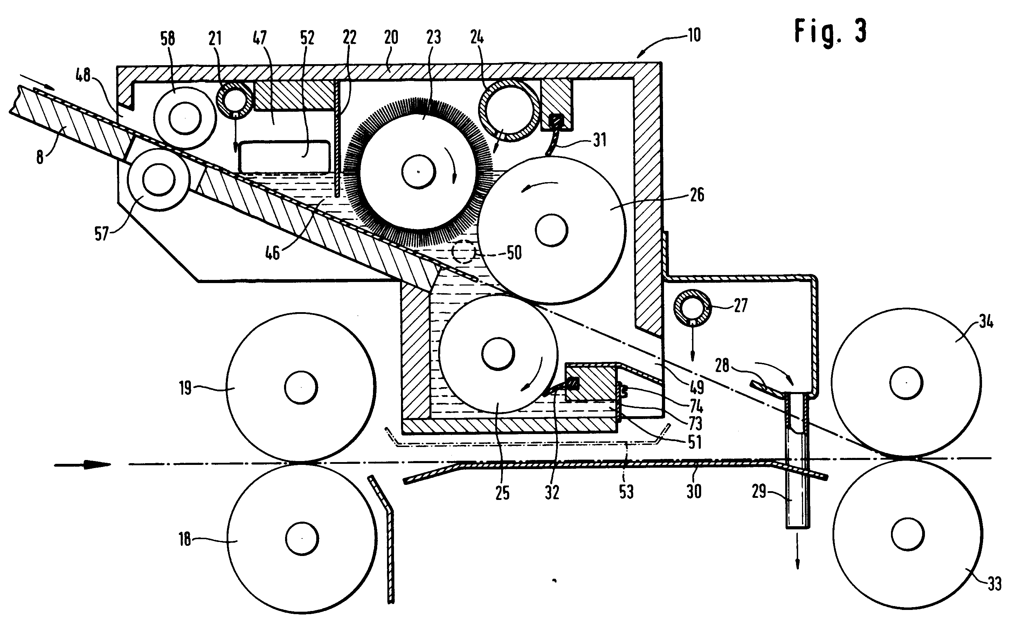

Für die Korrekturmittelabwaschstation sind die in Fig. 3 dargestellten Einlaufwalzen 57,58 nicht erforderlich. Sie werden nur als Einzugswalzenpaar bei der Verwendung der Vorrichtung als Entwicklerstation benötigt.

Wird die Vorrichtung 10 als Entwicklungsstation eingesetzt, so werden die Sprührohre 21, 24 und 50 von einem Vorratsbehälter 68 für Entwickler über eine Pumpe 69 mit Flüssigentwickler versorgt, wie dies aus Figur 2 ersichtlich ist, in der die Versorgungsleitungen, Pumpen, Vorratsbehälter und dergleichen Bauteile dünn eingezeichnet sind.

Anhand von Figur 3 wird die Vorrichtung 10 im folgenden näher beschrieben. Weiterhin ist mit dem Ausdruck "Flüssigkeit" bei dem Einsatz der Vorrichtung 10 als Korrekturmittel-Abwaschstation eine Reinigungsflüssigkeit, wie Wasser oder Wasser mit einem Zusatz, zu verstehen, und bei Verwendung der Vorrichtung 10 als Entwicklungsstation ein Flüssigentwickler gemeint. Die Vorrichtung 10 besteht im wesentlichen aus einer Vorkammer 47, die durch eine Trennwand 22 von dem Bürstenbereich getrennt ist. In der Vorkammer 47 befindet sich bei der Entwicklungsstation das Einlaufwalzenpaar 57, 58, das die über den zweiten geneigten Eingabetisch 8 eingeschobene Druckplatte erfaßt und weitertransportiert. Die Führungsbahn der Druckplatte ist im Bereich der Bürstenwalze 23 federnd gelagert und verstellbar, um eine Anpassung an die jeweilige Druckplattenstärke zu ermöglichen.

Das erste Sprührohr 21 dient zur Einspeisung von Flüssigkeit in die Vorweichzone eines Flüssigkeitsbades 46, das durch die Abquetschwalzen 25, 26 in Verbindung mit der Abdichtrakel 32 in dem Bürstenbereich der Vorrichtung 10 auf so ein hohes Flüssigkeitsniveau aufgestaut wird, daß das Flüssigkeitsbad bis in die Vorkammer 47 reicht, um die Vorweichzone zu bilden, und daß die vor dem Abquetschwalzenpaar 25, 26 angeordnete Bürstenwalze 23 teilweise in das Flüssigkeitsbad 46 eintaucht. Das Anstauen des Flüssigkeitsbades 46 und das Abquetschen der überschüssigen Flüssigkeit von der Plattenoberfläche werden durch das Abquetschwalzenpaar 25, 26 in Verbindung mit der Abdichtrakel 32 und durch das stirnseitig abdichtende Anliegen der Walzen 25, 26 an den Seitenschilden der Vorrichtung 10 durchgeführt. Die Abdeckhaube 20 schließt die Vorkammer 47 und die Bürstenwalze 23 sowie die Abquetschwalzen 25 und 26 ab und läßt nur die Eingabe- und Ausgabeöffnung 48 bzw. 49 für die Druckplatte frei. In dem aufgestauten Flüssigkeitsbad 46 in der Vorkammer 47 erfolgt eine Vorbehandlung der Druckplatte, im Sinne eines intensiven Vorweichens, und im Bürstenbereich wird die Druckplatte intensiv und in einer für die Kopierschicht sehr schonenden Weise durch die Bürstenwalze 23 unterhalb der Flüssigkeitsoberfläche gebürstet. Wichtig ist dabei, daß der Borstenbüschelbesatz der Bürstenwalze 23 vollständig mit Flüssigkeit durchsetzt ist, so daß beispielsweise auf der Druckplatte im Überschuß aufgetragenes Korrekturmittel oder die abzulösende Kopierschicht beim Einsatz der Vorrichtung 10 als Entwicklungsstation nicht an den Borsten haften können. Durch das teilweise Eintauchen der Bürstenwalze 23 in dem Flüssigkeitsbad 46 wird ferner ein Schäumen, durch ein nicht gezeigtes Abdeckblech über der Bürstenwalze 23 zur Vermeidung eines eventuellen Luftschöpfens der Bürstenwalze 23, bzw. durch spezielle Zusätze zu der Flüssigkeit, verhindert.

Das Flüssigkeitsniveau des Flüssigkeitsbades 46 wird durch einen oder zwei einstellbare Überläufe 52 in den Seitenschilden der Vorrichtung festgelegt.

Die Borstenbüschel der Bürstenwalze 23 sind beispielsweise von der Walzenmitte zu den Stirnflächen der Walze hin jeweils wendelförmig angeordnet, um ein sicheres Ableiten der abgelösten Partikel in Richtung der Überläufe zu gewährleisten. Anstelle einer Bürstenwalze kann auch eine Plüschwalze Anwendung finden.

Im Bürstenbereich der Vorrichtung 10 ist das zweite Sprührohr 24 zur Zuführung der Hauptflüssigkeitsmenge oberhalb der oberen Abquetschwalze 26 und nahe der Bürstenwalze 23 angeordnet. Die aus dem zweiten Sprührohr 24 austretende Flüssigkeit füllt auch bei maximaler Drehzahl der Bürstenwalze 23 die Borstenbüschelzwischenräume ausreichend, so daß der Bürstenbesatz vollständig mit Flüssigkeit durchsetzt ist. Die beiden Sprührohre 21 und 24 werden beispielsweise mit im Kreislauf gepumpter Flüssigkeit versorgt, und im Flüssigkeitsbad 46 zwischen der Bürstenwalze 23 und der oberen Abquetschwalze 26 befindet sich dann unmittelbar über der Durchlaufebene der Druckplatte das dritte Sprührohr 50, das mit frischer Flüssigkeit versorgt wird, beispielsweise Wasser aus dem Leitungsnetz zur fortgesetzten Wassererneuerung bei Verwendung der Vorrichtung 10 als Korrekturmittel-Abwaschstation oder mit Entwicklerkonzentrat beim Einsatz der Vorrichtung 10 als Entwicklungsstation.

Die Bürstenwalze 23 dreht vor der Berührung mit der Vorderkante der Druckplatte in Durchlaufrichtung. Nach dem Durchlauf der Vorderkante der Druckplatte durch die Berührungsstelle mit der Bürstenwalze 23 wird deren Drehrichtung umgeschaltet.

An der oberen Abquetschwalze 26 liegt im Bereich des Scheitelpunktes eine Rakel 31 oder ein sonstiger Spritzschutz an, der sicherstellt, daß abtropfende Flüssigkeit und eventuelle Spritzer in das aufgestaute Flüssigkeitsbad 46 laufen und nicht über den Scheitelpunkt der Abquetschwalze 26 auf die durchlaufende, abgequetschte Druckplatte gelangen.

Durch im Bereich der Vorweichzone seitlich angeordnete, einstellbare und niveaubegrenzende Überläufe 52, die sich in den Seitenschilden befinden und durch die von dem zweiten Sprührohr 24 eingeleitete Hauptflüssigkeitsmenge ergibt sich ein Gegenstrom der Flüssigkeit zur einlaufenden Druckplatte, der sicherstellt, daß im Bereich der Abquetschung durch das anstauende Abquetschwalzenpaar 25,26 stets saubere, d.h. gesiebte, gefilterte oder frische Flüssigkeit auf die Druckplatte gelangt.

An der tiefsten Stelle des Flüssigkeitsbades 46 ist seitlich ein verschließbarer Grundablaß 51 angeordnet, der während des Betriebs verschlossen ist und zum Auswechseln des Flüssigkeitsbades geöffnet wird. Der Grundablaß 51 kann beispielsweise durch eine Scheibe 73 verschlossen sein, die mittels einer Schraube 74 an die Gehäusewand der Vorrichtung 10 angeschraubt ist. Durch Verschwenken um die Schraube 74 ist es möglich, eine kleine Öffnung des Grundablasses 51 auch während des Betriebs der Vorrichtung 10 als Korrekturmittelabwaschstation geöffnet zu lassen, um sicherzustellen, daß auch nach dem Abschalten der Druckplattenentwicklungsmaschine 1 bzw. der Vorrichtung 10 das Flüssigkeitsbad 46 restlos auslaufen kann. Beim Wiedereinschalten der Vorrichtung 10 muß dann ein frisches Flüssigkeitsbad 46 aus dem Vorratsbehälter aufgestaut werden oder die umlaufende Flüssigkeitsmenge, falls das Flüssigkeitsbad 46 noch nicht völlig ausgelaufen ist, durch frische Flüssigkeit ergänzt werden. Bei Einsatz der Vorrichtung 10 als Korrekturmittelabwaschstation ist es in einer Ausgestaltung angebracht, das Flüssigkeitsbad nur mit frischem Leitungswasser aufzufüllen, da von der Druckplatte schädliche Korrekturmittelrestbestände abgewaschen werden, die nach Möglichkeit nicht im Kreislauf geführt werden sollen.

Im Auslaufbereich der Druckplatte befindet sich ein viertes Sprührohr 27 oberhalb der schrägen Durchlaufbahn der Druckplatte. Nahe der Austrittsöffnung 49 der Druckplatte ist eine Schöpfrinne 28 angeordnet, die in einem Auslaufrohr 29 mündet. Das von dem vierten Sprührohr 27 auf die Druckplattenoberfläche gesprühte und von dieser abprallende Spülwasser wird von der Schöpfrinne 28 aufgefangen und über das Auslaufrohr 29 in den Kreislauf des ersten bis dritten Sprührohres 21, 24, 50, die miteinander in Verbindung stehen, eingeleitet. Das vierte Sprührohr 27 ist identisch mit dem Sprührohr, das üblicherweise in der Spülstation 4 einer herkömmlichen Druckplattenentwicklungsmaschine 1, wie sie schematisch in Figur 1 dargestellt ist, verwendet wird. Das Sprührohr 27 dient zum definierten Spülen der Druckplattenoberfläche sowohl beim normalen, horizontalen Durchlauf zwischen den Walzen 18, 19 und den Walzen 33, 34 als auch beim Einsatz der Vorrichtung 10 als Korrekturmittelabwaschstation bzw. als Entwicklungsstation.

Wie schon zuvor erwähnt wurde, sammelt die in unmittelbarer Nachbarschaft des Sprührohres 27 angeordnete Schöpfrinne 28, bedingt durch ihre tiefere Anordnung gegenüber dem Sprührohr und die Neigung der abwärtslaufenden Druckplatte, den größten Teil des benutzten, relativ sauberen Spülwassers beim Plattendurchlauf ein. Dieses Spülwasser kann im Falle der Korrekturmittelabwaschung in den Kreislauf zur Versorgung der drei Sprührohre 21, 24 und 50 eingespeist werden, wenn das Korrekturmittel mit Wasser abgewaschen wird.

Unterhalb der Vorrichtung 10 befindet sich ein herausnehmbares Tropfblech 53, das über eine nicht gezeigte Verbindung zum Abfluß der Entwicklungsmaschine 1 verfügt. Das Tropfblech 53 ist zwischen der tiefsten Stelle der Vorrichtung 10 und der horizontalen Durchlaufebene der Druckplatte durch die Druckplattenentwicklungsmaschine 1 angeordnet, um ein Auftropfen und Aufspritzen des in der Vorrichtung 10 verwendeten Entwicklers auf die horizontal durchlaufende Druckplatte zu verhindern.

Beim Einsatz der Vorrichtung 10 als Entwicklerstation ist in einfacher Weise eine Erweiterung einer normalen Negativ-Druckplattenentwicklungsmaschine 1 mit dieser Entwicklungsstation für Positiv-Druckplatten möglich. Die Flüssigkeit in der Vorrichtung 10 ist dann ein Positiv-Entwickler für Druckplatten.

Beim Einsatz der Vorrichtung 10 als Korrekturmittelabwaschstation entfallen die Einzugswalzen 57, 58, ebenso das Tropfblech 53, das dann aus der Entwicklungsmaschine herausgenommen werden kann.

## Patentansprüche

1. Vorrichtung zum Verarbeiten von fotoempfindlichen Materialien, wie Druckplatten, mit einem schräg nach unten geneigten Eingabetisch, einem ersten Sprührohr mit Düsen zum Einspeisen von Flüssigkeit in die Vorrichtung, einer entgegengesetzt zur Materialdurchlaufrichtung rotierenden Bürstenwalze und einem Abquetschwalzenpaar, dadurch gekennzeichnet, daß das Abquetschwalzenpaar (25, 26), indem an der unteren Abquetschwalze (25) eine Abdichtrakel (32) anliegt, die die tiefste Stelle eines Flüssigkeitsbades (46) nach oben hin abschließt, das Flüssigkeitsbad (46) auf ein so hohes Flüssigkeitsniveau aufstaut, daß die in Materialdurchlaufrichtung vor dem Abquetschwalzenpaar angeordnete Bürstenwalze (23) in das Flüssigkeitsbad (46) teilweise eintaucht und daß das Flüssigkeitsbad bis in eine Vorkammer (47) aufgestaut ist, in der das erste Sprührohr (21) oberhalb des Flüssigkeitsniveaus angeordnet ist und Flüssigkeit in das Flüssigkeitsbad ohne Abspritzen der Materialoberfläche einspeist.

2. Vorrichtung nach Anspruch 1, dadurch gekennzeichnet, daß die Bürstenwalze (23) und die Abquetschwalzen (25, 26) an den Seitenschilden der Vorrichtung (10) stirnseitig abgedichtet anliegen.

3. Vorrichtung nach Anspruch 1, dadurch gekennzeichnet, daß eine Abdeckhaube (20) die Vorkammer (47) und die Bürstenwalze (23) sowie die Abquetschwalzen (25,26) abdeckt und die Eingabe- und Ausgabeöffnung (48 bzw. 49) für das fotoempfindliche Material jeweils an einer Seite begrenzt.

4. Vorrichtung nach Anspruch 3, dadurch gekennzeichnet, daß die Vorkammer (47) durch eine Trennwand (22) von der Bürsten- und den Abquetschwalzen getrennt ist.

5. Vorrichtung nach Anspruch 1, dadurch gekennzeichnet, daß ein zweites Sprührohr (24) für die Zufuhr der Hauptflüssigkeitsmenge an die entgegen der Materialdurchlaufrichtung rotierenden Bürstenwalze (23) oberhalb der oberen Abquetschwalze (26) und des Flüssigkeitspegels so angeordnet ist, daß die aus den Düsen austretende Flüssigkeit die Zwischenräume der Bürstenbüschel der Bürstenwalze (23) füllt und daß der Bürstenbesatz vollständig mit Flüssigkeit durchsetzt ist.

6. Vorrichtung nach Anspruch 5, dadurch gekennzeichnet, daß zwischen der Bürstenwalze (23) und der oberen Abquetschwalze (26) unmittelbar über dem zweiten, schrägen Eingabetisch (8) ein drittes Sprührohr (50) sich befindet, das dem Flüssigkeitsbad frische Flüssigkeit zuführt.

7. Vorrichtung nach Anspruch 5, dadurch gekennzeichnet, daß das erste und zweite Sprührohr (21,24) miteinander in Verbindung stehen und mit im Kreislauf gepumpter Flüssigkeit versorgt sind.

8. Vorrichtung nach Anspruch 2, dadurch gekennzeichnet, daß an der oberen Abquetschwalze (26) eine Rakel (31) anliegt, die oberhalb des oberen Scheitelpunktes der Abquetschwalze (26) angeordnet ist.

9. Vorrichtung nach Anspruch 1, dadurch gekennzeichnet, daß an der tiefsten Stelle des Flüssigkeitsbades (46) ein verschließbarer Grundablaß (52) angeordnet ist, der während des Betriebs verschlossen und zum Auswechseln des Flüssigkeitsbades geöffnet ist.

10. Vorrichtung nach Anspruch 1, dadurch gekennzeichnet, daß im Auslaufbereich des fotoempfindlichen Materials ein viertes Sprührohr (27) oberhalb der schrägen Durchlaufbahn des Materials angeordnet ist und daß nahe der Austrittsöffnung (49) des Materials sich eine Schöpfrinne (28) und ein Auslaufrohr (29) befinden, die das auf die Materialoberfläche gesprühte und von dieser abprallende Spülwasser in den Kreislauf des ersten, zweiten und dritten Sprührohres (21,24,50) einleiten.

11. Vorrichtung nach Anspruch 5, dadurch gekennzeichnet, daß in den Seitenschilden der Vorkammer (46) je ein verstellbarer Überlauf (52) angeordnet ist, und daß sich im Zusammenwirken der Überläufe mit dem zweiten Sprührohr (24) ein Gegenstrom an Flüssigkeit zur Materialdurchlaufrichtung einstellt.

**12.** Vorrichtung nach Anspruch 1, dadurch gekennzeichnet, daß sie eine Korrekturmittel-Abwaschvorrichtung ist, die auf eine an sich bekannte Entwicklungsmaschine (1) für fotoempfindliche Materialien aufmontiert ist und daß die Flüssigkeit zum Abwaschen des Korrekturmittels von der Materialoberfläche Wasser ist.

**13.** Vorrichtung nach Anspruch 1, dadurch gekennzeichnet, daß sie eine Entwicklungsvorrichtung ist, die auf eine an sich bekannte Entwicklungsmaschine (1) für fotoempfindliche Materialien befestigt ist, daß in der Vorkammer (47) ein Einlaufwalzenpaar (54,55) angeordnet ist und die Flüssigkeit zum Entwickeln des fotoempfindlichen Materials ein Entwickler ist.

**14.** Vorrichtung nach Anspruch 13, dadurch gekennzeichnet, daß ein Tropfblech (53) zwischen der Vorrichtung (10) und der horizontalen Durchlaufbahn des fotoempfindlichen Materials angeordnet ist, und daß das Tropfblech (53) herausnehmbar ist und mit dem Abfluß der Entwicklungsmaschine (1) verbunden ist.

**15.** Vorrichtung nach Anspruch 13 oder 14, dadurch gekennzeichnet, daß die Bürstenwalze (23) vor der Berührung mit der Vorderkante der Druckplatte in Durchlaufrichtung sich dreht und daß die Drehrichtung der Bürstenwalze (23) nach dem Durchlauf der Vorderkante der Druckplatte durch die Berührungsstelle mit der Bürstenwalze (23) umgeschaltet wird.

**16.** Vorrichtung nach Anspruch 1, dadurch gekennzeichnet, daß die Drehzahl der Bürstenwalze (23) einstellbar ist.

**17.** Vorrichtung nach Anspruch 1, dadurch gekennzeichnet, daß die Führungsbahn der Druckplatte im Bereich der Bürstenwalze (23) federnd gelagert und verstellbar ist.

**18.** Vorrichtung nach Anspruch 1, dadurch gekennzeichnet, daß die Borstenbüschel der Bürstenwalze (23) von der Walzenmitte zu den Stirnflächen der Walze hin eine wendelförmige Anordnung zum Ableiten der losgelösten Partikel in Richtung Überlauf (52) aufweisen.

**Claims**

**1.** Device for processing photo-sensitive materials such as printing plates, comprising an obliquely downwardly inclined feed table, a first spray tube with nozzles for feeding fluid into the device, a brush roller rotating in the opposite direction of the direction of passage of the material, and a pair of squeeze rollers, wherein - by means of a sealing blade (32) closing the lowest point of the fluid bath (46) towards the top and resisting against the lower squeeze roller (25) - the pair of squeeze rollers (25, 26) banks up a fluid bath (46) to such a high fluid level that the brush roller (23) disposed in front of the pair of squeeze rollers in the direction of material passage is partially immersed in the fluid bath (46) and the fluid bath is banked up into an antechamber (47) in which the first spray tube (21) is disposed above the fluid level and feeds fluid into the fluid bath without spraying the surface of the material.

**2.** Device as claimed in Claim 1, wherein the brush roller (23) and the squeeze rollers (25, 26) rest in a manner sealed at the front end against the side shields of the device (10).

**3.** Device as claimed in Claim 1, wherein a covering hood (20) covers the antechamber (47) and the brush roller (23) and the squeeze rollers (25, 26) and in each case limits on one side the feed and discharge opening (48 and 49, respectively) for the photo-sensitive material.

**4.** Device as claimed in Claim 3, wherein the antechamber (47) is separated from the brush roller and the squeeze rollers by a partition (22).

**5.** Device as claimed in Claim 1, wherein a second spray tube (24) for supplying the main fluid volume to the brush roller (23), rotating in the opposite direction of the direction of passage of the material, is disposed above the upper squeeze roller (26) and the fluid level in such a manner that the fluid emerging from the nozzles fills the spaces between the tufts of bristles of the brush roller (23) and the cover of bristles is completely penetrated by fluid.

**6.** Device as claimed in Claim 5, wherein a third spray tube (50), which supplies fresh fluid to the fluid bath, is located immediately above the second inclined feed table (8) between the brush roller (23) and the upper squeeze roller (26).

**7.** Device as claimed in Claim 5, wherein the first and second spray tubes (21, 24) are connected to one another and are supplied with fluid pumped in a circuit.

8. Device as claimed in Claim 2, wherein a doctor blade (31), which is dipsosed above the upper crown of the squeeze roller (26), rests against the upper squeeze roller (26).

9. Device as claimed in Claim 1, wherein a closeable bottom drain (52), which is closed during operation and is opened for replacing the fluid bath is disposed at the lowest point of the fluid bath (46).

10. Device as claimed in Claim 1, wherein a fourth spray tube (27) is disposed above the inclined path of passage of the material in the discharge area of the photo-sensitive material, and a scoop trough (28) and a drainpipe (29) are located close to the discharge opening (49) of the material and introduce the rinsing water sprayed onto the surface of the material and bouncing off the latter into the circuit of the first, second and third spray tube (21, 24, 50).

11. Device as claimed in Claim 5, wherein one adjustable overflow (52) each is arranged in the side shields of the antechamber (47) and a counter flow of fluid with respect to the direction of passage of the material occurs in the overflows acting in conjunction with the second spray tube (24).

12. Device as claimed in Claim 1, wherein it is a correcting agent washing device which is mounted onto a developing machine (1) for photo-sensitive materials, known per se, and the fluid for washing the correcting agent from the material surface is water.

13. Device as claimed in Claim 1, wherein it is a developing device which is attached to a developing machine (1) for photo-sensitive materials, known per se, a pair of feed rollers (54, 55) is arranged in the antechamber (47) and the fluid for developing the photo-sensitive material is a developer.

14. Device as claimed in Claim 13, wherein a dripping plate (53) is arranged between the device (10) and the horizontal path of passage of the photo-sensitive material and the dripping plate (53) is removable and is connected to the drain of the developing machine (1).

15. Device as claimed in Claim 13 or 14, wherein the brush roller (23), before coming into contact with the front edge of the printing plate, rotates in the direction of passage, and the direction of rotation of the brush roller (23) is reversed after the front edge of the printing plate has passed through the point of contact with the brush roller (23).

16. Device as claimed in Claim 1, wherein the speed of rotation of the brush roller (23) is adjustable.

17. Device as claimed in Claim 1, wherein the path of guidance of the printing plate is spring supported and adjustable in the area of the brush roller (23).

18. Device as claimed in Claim 1, wherein the tufts of bristles of the brush roller (23) exhibit a helical arrangement from the center of the roller towards the front area of the roller for conducting the detached particles away in the direction of drain (52).

**Revendications**

1. Dispositif pour traiter des matériaux photosensibles, tels que des plaques d'impression, comportant une table d'introduction inclinée obliquement vers le bas, un premier tube de pulvérisation comportant des buses destinées à introduire un liquide dans le dispositif, un rouleau-brosse tournant en sens opposé de la direction de passage du matériau, et un couple de rouleaux essoreurs, caractérisé en ce que le couple de rouleaux essoreurs (25,26), contre le rouleau essoreur inférieur (25) duquel s'applique une raclette d'étanchéité (32), qui ferme, vers le haut, le point le plus bas d'un bain de liquide (46), refoule le bain de liquide (46) à un niveau de liquide suffisamment élevé pour que le rouleau-brosse (23), disposé en amont du couple de rouleaux essoreurs dans la direction de passage du matériau, pénètre en partie dans le bain de liquide (46), et que le bain de liquide est refoulé jusque dans une chambre amont (47), dans laquelle le premier tube de pulvérisation (21) est disposé au-dessus du niveau du liquide et introduit le liquide dans le bain de liquide sans aucune pulvérisation sur la surface du matériau.

2. Dispositif selon la revendication 1, caractérisé en ce que le rouleau-brosse (23) et les rouleaux d'essorage (25,26) s'appliquent frontalement, d'une manière étanche, contre les panneaux latéraux du dispositif (10).

3. Dispositif selon la revendication 1, caractérisé en ce qu'un capot de recouvrement (20) limite la chambre amont (47) et recouvre le rouleau-brosse (23) ainsi que les rouleaux essoreurs (25,26) et limite respectivement d'un côté l'ouverture d'entrée et l'ouverture de sortie (48 et 49) pour le matériau photosensible.

4. Dispositif selon la revendication 3, caractérisé en ce que la chambre amont (47) est séparée du rouleau-brosse et des rouleaux essoreurs par une paroi de séparation (22).

5. Dispositif selon la revendication 1, caractérisé en ce qu'un second tube de pulvérisation (24) pour l'introduction de la quantité principale de liquide au rouleau-brosse (23) tournant en sens opposé de la direction de passage du matériau, est disposé au-dessus du rouleau d'essorrage supérieur (26) et du niveau du liquide, de sorte que le liquide, qui sort des buses, remplit les espaces intercalaires présents entre les touffes de poils formant brosse du rouleau-brosse (23) et que le liquide traverse complètement le revêtement formant brosse.

6. Dispositif selon la revendication 5, caractérisé en ce qu'entre le rouleau-brosse (23) et le rouleau essoreur supérieur (26) est disposé, directement au-dessus de la seconde table oblique d'introduction (8), un troisième tube de pulvérisation (50), qui envoie du liquide frais au bain de liquide.

7. Dispositif selon la revendication 5, caractérisé en ce que les premier et second tubes de pulvérisation (21,24) sont raccordés entre eux et alimentés par un liquide introduit par pompage dans le circuit.

8. Dispositif selon la revendication 2, caractérisé en ce que contre le rouleau essoreur supérieur (26) s'applique une racle (31), qui est disposée au-dessus du point sommital supérieur du rouleau essoreur (26).

9. Dispositif selon la revendication 1, caractérisé en ce qu au niveau du point le plus bas du bain de liquide (46) est disposé un dispositif d'évacuation de fond pouvant être fermé (52), qui est fermé pendant le fonctionnement et est ouvert pour le remplacement du bain de liquide.

10. Dispositif selon la revendication 1, caractérisé en ce qu'un quatrième tube de pulvérisation (27) est disposé, dans la zone de sortie du matériau photosensible, au-dessus de la voie oblique de circulation du matériau et qu'à proximité de l'ouverture de sortie (49) du matériau sont disposés une goulotte d'aspiration (28) et un tube d'évacuation (29), qui introduisent l'eau de lavage, qui est pulvérisée sur la surface du matériau et rebondit sur ce dernier, dans le circuit des premier, second et troisième tubes de pulvérisation (21,24,50).

11. Dispositif selon la revendication 5, caractérisé en ce qu un trop-plein réglable (52) est disposé dans chacun des panneaux latéraux de la chambre amont (47) et qu'un écoulement de liquide est réglé en sens opposé de la direction de déplacement du matériau, les trop-pleins coopérant avec le second tube de pulvérisation (24).

12. Dispositif selon la revendication 1, caractérisé en ce qu'il s'agit d'un dispositif d'élimination par lavage de l'agent de correction, qui est monté sur une machine de développement connue en soi pour des matériaux photosensibles, et que le liquide servant à éliminer par lavage l'agent de correction, de la surface du matériau est de l'eau.

13. Dispositif selon la revendication 1, caractérisé en ce qu'il s'agit d'un dispositif de développement, qui est fixé sur une machine connue en soi (1) de développement de matériaux photosensibles, qu un couple de rouleaux d'entrée (54,55) est disposé dans la chambre amont (47) et que le liquide servant à développer le matériau photosensible est un révélateur.

14. Dispositif selon la revendication 13, caractérisé en ce qu'une tôle d'égouttage (53) est disposée entre le dispositif (10) et la voie horizontale de passage du matériau photosensible, et que la tôle d'égouttage (53) est amovible et est raccordée au système d'évacuation de la machine de développement (1).

15. Dispositif selon la revendication 13 ou 14, caractérisé en ce qu avant la venue en contact avec le bord avant de la plaque d'impression, le rouleau-brosse (23) tourne dans le sens de passage du matériau et que le sens de rotation du rouleau-brosse (23) est inversé après que le bord avant de la plaque d'impression a franchi le point de contact avec le rouleau-brosse (23).

16. Dispositif selon la revendication 1, caractérisé en ce que la vitesse de rotation du rouleau-brosse (23) est réglable.

17. Dispositif selon la revendication 1, caractérisé en ce que la voie de guidage de la plaque d'impression est supportée élastiquement et ajustable dans la zone du rouleau-brosse (23).

**18.** Dispositif selon la revendication 1, caractérisé en ce que les touffes de poils de la brosse du rouleau-brosse (23) sont disposées selon une disposition hélicoïdale, du centre jusqu'aux faces frontales du rouleau, pour l'évacuation des particules détachées, en direction du trop-plein (52).

Fig. 1

Fig. 2

EP 0 260 615 B1

Fig. 3